(19) **Europäisches Patentamt European Patent Office Office européen des brevets**

(11) **EP 3 249 689 B1**

(12) **FASCICULE DE BREVET EUROPEEN**

(45) Date de publication et mention de la délivrance du brevet:
**17.03.2021 Bulletin 2021/11**

(51) Int Cl.:
*H01L 27/12* (2006.01)    *H01L 21/84* (2006.01)
*H01L 29/66* (2006.01)    *H01L 29/786* (2006.01)

(21) Numéro de dépôt: **17172067.5**

(22) Date de dépôt: **19.05.2017**

(54) **PROCÉDÉ DE FORMATION DE TRANSISTORS PDSOI ET FDSOI SUR UN MÊME SUBSTRAT**

VERFAHREN ZUR BILDUNG VON PDSOI- UND FDSOI-TRANSISTOREN AUF DEMSELBEN SUBSTRAT

METHOD FOR FORMING PDSOI AND FDSOI TRANSISTORS ON A SINGLE SUBSTRATE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.05.2016 FR 1654651**

(43) Date de publication de la demande:
**29.11.2017 Bulletin 2017/48**

(73) Titulaire: **X-FAB FRANCE**
**91105 Corbeil Essonnes Cedex (FR)**

(72) Inventeurs:
• **COSTAGANNA, Pascal**
**77930 CHAILLY EN BIERE (FR)**

• **DOMART, Francis**
**91540 MENNECY (FR)**
• **U'REN, Gregory**
**78460 CHEVREUSE (FR)**

(74) Mandataire: **Hautier, Nicolas**
**Cabinet Hautier**
**20, rue de la Liberté**
**06000 Nice (FR)**

(56) Documents cités:
**WO-A1-03/054966    US-A1- 2002 072 225**
**US-A1- 2006 216 898**

**Description**

DOMAINE TECHNIQUE DE L'INVENTION

La présente invention concerne le domaine de la microélectronique et de la nanoélectronique et plus particulièrement le domaine des transistors partiellement désertés et des transistors totalement désertés montés sur une même tranche de semi-conducteur.

ETAT DE LA TECHNIQUE

Dans le domaine des circuits intégrés formés à partir de substrats élaborés de type semi-conducteur sur isolant, désignés par leur acronyme SOI, de l'anglais « Semiconductor On Insulator », il existe généralement deux types de transistors utilisés : Des transistors dits partiellement désertés désignés par leur acronyme PDSOI, de l'anglais « Partially Depleted Semiconductor On Insulator », et des transistors dits totalement désertés désignés par leur acronyme FDSOI, de l'anglais « Fully Depleted Semiconductor On Insulator ».

Un substrat élaboré SOI est caractérisé par la présence d'une fine couche superficielle de semi-conducteur monocristallin, du silicium monocristallin par exemple, reposant sur une couche continue isolante d'oxyde, par exemple d'oxyde de silicium, dit oxyde enterré ou encore BOX acronyme de l'anglais « Buried Oxide layer ». La solidité et la rigidité mécanique de l'ensemble sont assurées par une couche sur laquelle repose la BOX et qui constitue le corps du substrat SOI, souvent qualifié du vocable anglais de « bulk » pour indiquer que le substrat de départ est très généralement fait d'un matériau semi-conducteur massif, du silicium par exemple. Cette structure offre de nombreux avantages pour la réalisation des transistors MOS acronyme de l'anglais « Metal-Oxide-Semiconductor ». Notamment, elle permet une réduction drastique des capacités parasites en raison de la présence de la couche continue isolante.

Les deux types de transistors FDSOI et PDSOI répondent à des besoins spécifiques dans le domaine de l'électronique analogique et numérique, et plus particulièrement dans le domaine de l'électronique radiofréquence.

Il est ainsi connu de l'art antérieur des dispositifs électroniques comprenant des transistors FDSOI et des transistors PDSOI sur des mêmes puces électroniques, comme par exemple le document WO 03/054966 A1 qui décrit un procédé de formation d'une puce microélectronique comprenant des transistors FDSOI et PDSOI ; ou encore le document US 2006/0216898 A1 qui décrit également un procédé de formation d'un transistor FDSOI et d'un transistor PDSOI sur une même puce microélectronique ; ou plus généralement le document US 2002/0072225 A1 qui divulgue un procédé de gravure de matériaux semi-conducteurs.

L'art antérieur présente alors plusieurs solutions de formation de ce type de dispositifs électroniques.

Toutefois des solutions s'avèrent relativement complexes et couteuses à mettre en oeuvre afin d'obtenir de manière reproductible et sur une même puce des transistors dont les performances sont élevées. Il existe donc un réel besoin de simplifier la fabrication et de diminuer les coûts de production de ce type de dispositifs électroniques.

RESUME DE L'INVENTION

La présente invention concerne un procédé de formation d'un dispositif électronique destiné à accueillir au moins un transistor totalement déserté (FDSOI) et au moins un transistor partiellement déserté (PDSOI), à partir d'un empilement de couches comprenant au moins une couche isolante surmontée d'au moins une couche active en un matériau semi-conducteur, le procédé comprenant au moins les étapes suivantes :

- Former au moins une tranchée isolante à travers l'épaisseur de la couche active pour définir dans ladite couche active, de part et d'autre de la tranchée isolante, au moins une première région active sur laquelle est destiné à être formé au moins un transistor partiellement déserté (PDSOI) et au moins une deuxième région active sur laquelle est destiné à être formé au moins un transistor totalement déserté (FDSOI) ;
- Former, au-dessus de l'au moins une première région active et sur une partie de la tranchée isolante, une couche de masquage sans recouvrir l'au moins une deuxième région active et sans recouvrir une partie de la tranchée isolante ;
- Graver simultanément par une gravure sèche de sorte à former des zones gravées :

  ◦ une partie de l'épaisseur de la couche active de l'au moins une deuxième région active de manière à former au moins une deuxième région active amincie et à obtenir, dans l'au moins une deuxième région active amincie, une épaisseur de la couche active plus faible que dans l'au moins une première région active ;
  ◦ au moins une partie de l'épaisseur de la partie non recouverte de la tranchée isolante de sorte à former une partie gravée de la tranchée isolante ;
  ◦ et la totalité de la couche de masquage.

- Ajuster, après l'étape de gravure sèche, la hauteur de la surface de l'au moins une deuxième région active amincie à la hauteur de la surface de ladite partie gravée de la tranchée isolante, l'étape d'ajustement de la hauteur de la surface de l'au moins une deuxième région active amincie à la hauteur de la surface de ladite partie gravée de la tranchée isolante comprenant au moins les étapes suivantes:
- oxydation d'au moins une portion de la deuxième région active amincie de sorte à former une couche d'oxyde sacrificielle;

- retrait partiel de la couche d'oxyde sacrificielle de sorte à former une couche d'oxyde sacrificielle résiduelle et de sorte à ce que la surface de la couche d'oxyde sacrificielle résiduelle soit à la même hauteur que la surface de la partie gravée de la tranchée isolante.

La présente invention permet de former sur un même substrat semi-conducteur de préférence de type SOI, une pluralité de transistors partiellement désertés de type PDSOI et de transistors totalement désertés de type FDSOI en un minimum d'étapes par l'utilisation d'étapes à la fois économiques en termes de temps de procédé mais également par rapport aux chimies utilisées couramment dans l'art antérieur. La présente invention bénéficie en effet d'une synergie de ces étapes afin de maximiser l'utilité de chacune d'entre elles tout en minimisant leur nombre.

Cette synergie repose sur deux étapes que sont une étape de gravure sèche et une étape de formation d'une couche d'oxyde sacrificielle : la gravure sèche permet de graver simultanément une pluralité de couches et de matériaux différents et la couche d'oxyde sacrificielle permet d'améliorer les performances du transistor FDSOI tout en facilitant la formation des zones de sources et de drains par son effet d'écrantage lors des étapes d'implantation ionique ultérieures.

La gravure sèche est une étape permettant d'amincir rapidement et simplement une région de la couche active tout en amincissant une portion des tranchées isolantes environnant ladite région amincie de la couche active.

Avantageusement, cette étape de gravure sèche permet de retirer la couche de masquage, nommée également masque dur, des zones PDSOI en même temps qu'elle permet d'amincir une région de la couche active et une portion des tranchées isolantes. Afin d'être en mesure de graver simultanément trois matériaux de nature différente et cela de manière à ce que l'épaisseur d'amincissement souhaitée corresponde à la gravure complète d'un des trois matériaux, de préférence la couche de masquage, le choix de leur nature et de leur structure est un point critique, tout comme le choix de la gravure sèche.

Avantageusement, un oxyde, de préférence de silicium, formé par dépôt chimique en phase vapeur assisté par plasma dit oxyde LPCVD de l'acronyme anglais « Low-Pressure Chemical Vapor Déposition » et un oxyde, de préférence de silicium, formé par dépôt chimique en phase vapeur réalisée à pression sous-atmosphérique dit oxyde PECVD de l'acronyme « Plasma-enhanced chemical vapor deposition » ont été astucieusement choisis afin de satisfaire cette condition. L'oxyde PECVD forme les tranchées isolantes tandis que l'oxyde LPCVD forme la couche de masquage. Ainsi, une seule étape de gravure permet ainsi de graver trois matériaux différents dans les conditions d'amincissement et de retrait souhaitées.

Cette étape de gravure sèche conduit cependant à la formation de gouttières au niveau de la jonction entre la région amincie de la couche active et les parties gravées des tranchées isolantes. Ces gouttières résultent directement de la nature de la gravure sèche à l'interface entre deux matériaux différents et entraînent la formation ultérieure de rails de matériau polycristallin dans les étapes postérieures de la formation des transistors FDSOI. Ce phénomène de formation de gouttières, dit de « Microtrenching » en anglais, est bien connu de l'Homme du métier et l'aurait ainsi dissuadé d'utiliser une gravure sèche afin d'amincir la couche active ainsi qu'une partie des tranchées isolantes.

En effet, à première vue, ces gouttières laissent penser que les performances des transistors FDSOI seront amoindries. Toutefois, au cours du développement de la présente invention, les effets de ces gouttières sur les performances des transistors ont pu être maîtrisés. De manière surprenante, l'étape d'ajustement de la hauteur de la surface de l'au moins une deuxième région amincie active à la hauteur de la surface de ladite partie gravée de la tranchée isolante permet de maîtriser la structure de ces gouttières de telle sorte qu'elles ne nuisent pas aux performances des transistors FDSOI.

Concernant l'utilisation d'une couche d'oxyde sacrificielle, celle-ci assure au moins trois fonctions distinctes en synergie avec la problématique de la réduction du coût de fabrication et avec l'étape précédente de gravure sèche.

En effet, cette couche d'oxyde sacrificielle permet, d'une part d'améliorer l'état de surface de la couche active amincie en éliminant les défauts de surface de la région amincie de la couche active induits par la gravure sèche, et d'autre part d'ajuster la hauteur de cette région amincie de la couche active à la hauteur de la surface de la partie gravée de la tranchée isolante de sorte à éliminer les nuisances des gouttières et optimiser les performances du transistor FDSOI, tout en conservant des étapes exécutables simplement pour obtenir ledit transistor.

La présente invention concerne également un dispositif électronique destiné à accueillir au moins un transistor totalement déserté de type FDSOI et au moins un transistor partiellement déserté de type PDSOI obtenu par le procédé selon la présente invention.

BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

- La figure 1 illustre, selon un mode de réalisation de la présente invention, un substrat de type SOI comprenant avantageusement une pluralité de couches situées à la surface d'une structure SOI dont une couche de masquage. C'est de préférence à partir de ce type d'empilement de couches que la présente invention peut être mise en oeuvre.

- La figure 2 illustre, selon un mode de réalisation de la présente invention, une étape de dépôt d'une résine destinée à masquer les futures régions PDSOI.
- La figure 3 illustre, selon un mode de réalisation de la présente invention, le retrait de ladite pluralité de couches au niveau de la future région FDSOI.
- La figure 4 illustre, selon un mode de réalisation de la présente invention, une étape de gravure sèche après avoir retiré ladite résine. Cette étape de gravure sèche a pour objectif, entre autre, d'amincir les couches non recouvertes par ladite couche de masquage.
- La figure 5 illustre, selon un mode de réalisation de la présente invention, l'état du substrat après l'étape de gravure sèche avec la présence d'une couche d'oxyde résiduelle et la présence de gouttières.
- La figure 6 illustre, selon un mode de réalisation de la présente invention, une étape de nettoyage humide configurée pour supprimer ladite couche d'oxyde résiduelle.
- La figure 7 illustre, selon un mode de réalisation de la présente invention, une étape de formation d'une couche d'oxyde sacrificielle à la surface de la couche active amincie.
- La figure 8 illustre, selon un mode de réalisation de la présente invention, une étape d'ajustement de la hauteur de la couche d'oxyde sacrificielle à la hauteur de la couche d'oxyde PECVD.
- La figure 9 illustre, selon un mode de réalisation de la présente invention, une étape de retrait d'une couche de nitrure.
- La figure 10 illustre, selon un mode de réalisation de la présente invention, une étape d'implantation ionique afin de former des zones de sources et de drains.
- La figure 11 illustre, selon un mode de réalisation de la présente invention, un transistor FDSOI et deux transistors PDSOI formés selon un exemple de mise en oeuvre de la présente invention.

Les dessins joints sont donnés à titre d'exemples et ne sont pas limitatifs de l'invention. Ces dessins sont des représentations schématiques et ne sont pas nécessairement à l'échelle de l'application pratique. En particulier, les épaisseurs relatives des couches et des substrats ne sont pas représentatives de la réalité.

## DESCRIPTION DETAILLEE DE L'INVENTION

On entend par transistor PDSOI ou plus généralement dispositif PDSOI, un dispositif construit dans une zone dont l'épaisseur est plus grande que la couche maximale de déplétion (en anglais maximum depletion layer) $W_{d\_max}$.

On entend par transistor FDSOI ou plus généralement dispositif FDSOI, un dispositif construit dans une zone dont l'épaisseur est plus faible que la couche maximale de déplétion (en anglais maximum depletion layer) $W_{d\_max}$.

L'épaisseur de cette couche maximale de déplétion $W_{d\_max}$ est donnée par l'équation :

$$W_{d\_max} = (2\varepsilon_{si}\varepsilon_0 2\varphi_F /qN_A)^{1/2}$$

Avec :

- $\varepsilon_{si}$ : la constante diélectrique relative du silicium ;
- $\varepsilon_0$ : la constante diélectrique absolue du vide ;
- $\varphi_F = (kT/q) \ln(N_A/n_i)$-;
- $k$ : la constante de Boltzmann ;
- T : la température ;
- $n_i$ : la concentration intrinsèque de porteurs du silicium ;
- q : la charge électrique élémentaire ;
- $N_A$ : la concentration en impuretés.

Ce qui à la température ambiante (300 K) donne $\varphi_F =0.0259 \ln(N_A/1.5\times10^{10})$

Dans ce qui suit, on entend par :

- « zone PDSOI », une zone du substrat destinée à recevoir au moins un transistor PDSOI et comprenant une couche active et une partie des tranchées isolantes situées de part et d'autre de la couche active considérée.
- « zone FDSOI », une zone du substrat destinée à recevoir au moins un transistor FDSOI et comprenant une couche active et une partie des tranchées isolantes situées de part et d'autre de la couche active considérée.
- « région active PDSOI », une région du substrat comprenant une couche active destinée à la formation d'au moins un transistor PDSOI.
- « région active FDSOI », une région du substrat comprenant une couche active destinée à la formation d'au moins un transistor FDSOI.
- « oxyde PECVD », un oxyde formé par dépôt chimique en phase vapeur assisté par plasma.
- « oxyde LPCVD », un oxyde formé par dépôt chimique en phase vapeur réalisé à pression sous-atmosphérique.

Il est précisé que dans le cadre de la présente invention, le terme « tranche », « substrat » ou « puce » ou leurs équivalents ont pour définition un dispositif comprenant avantageusement une ou plusieurs couches de semi-conducteurs et configuré pour recevoir la formation de structures semi-conductrices de type transistors par exemple.

Il est précisé que dans le cadre de la présente invention, le terme « Substrat SOI », ou ses équivalents ont pour définition un substrat caractérisé par la présence d'une couche superficielle de semi-conducteur monocristallin, du silicium monocristallin par exemple, reposant sur une couche continue isolante d'oxyde, par exemple d'oxyde de silicium, dit oxyde enterré ou encore BOX acronyme de l'anglais « buried oxide layer ». La solidité et la rigidité mécanique de l'ensemble sont assurées par une couche de support par exemple en silicium.

Il est précisé que, dans le cadre de la présente invention, les termes « sur », « surmonte » ou « sousjacent » ou leurs équivalent ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant, soit directement à son contact, soit en étant séparée d'elle par une autre couche ou un autre élément.

Dans la description qui suit, les épaisseurs sont généralement mesurées selon des directions perpendiculaires au plan de la face inférieure de la couche à graver ou d'un substrat sur lequel la couche inférieure est disposée. Ainsi, les épaisseurs sont généralement prises selon une direction verticale sur les figures représentées.

Dans la description qui suit, on entend par « même hauteur » ou par ses équivalents, le fait que deux surfaces distinctes soient situées dans un même plan parallèle au substrat c'est-à-dire, relativement aux figures de l'exemple non limitatif, le fait que deux surfaces distinctes soient situées dans un même plan horizontal.

Dans ce qui suit, on entend par « mise à niveau », « ajustement de hauteur » ou par leurs équivalents, le fait de modifier l'épaisseur d'une couche de sorte à ce que sa surface soit située dans même plan que la surface d'une autre couche, typiquement un même plan horizontal relativement aux figures de l'exemple non limitatif.

Dans le cadre de la présente invention, on qualifie de résine un matériau organique ou organo-minéral pouvant être mis en forme par une exposition à un faisceau d'électrons, de photons ou de rayons X ou mécaniquement.

Dans ce qui suit, on entend par « gravure » l'enlèvement partiel ou total d'un matériau donné.

Dans ce qui suit, on entend par « gravure humide », une technique de gravure nécessitant l'utilisation d'une chimie en milieu humide, par des bains généralement.

Dans ce qui suit, on entend par « gravure sèche », une technique de gravure dans un milieu non humide, et de préférence par l'utilisation d'un plasma.

On entend par « conforme », une géométrie de couches qui présente, aux tolérances de fabrication près, une épaisseur constante malgré les changements de direction des couches, par exemple au niveau de flancs verticaux de certaines structures.

Le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

On entend par « structure » d'un matériau, la répartition spatiale de ses constituants élémentaires d'un point de vue cristallographique. Ainsi deux couches d'un même matériau peuvent être de même nature mais présenter des structures cristallines différentes l'une de l'autre.

On entend par « nature » d'un matériau, sa composition chimique et/ou sa structure cristalline. Ainsi deux couches peuvent être de même composition chimique mais de nature différente d'un point de vue cristallographique.

Avant d'entamer une revue détaillée de modes de réalisation de l'invention, sont énoncées ci-après des caractéristiques optionnelles qui peuvent éventuellement être utilisées en association ou alternativement :

- Avantageusement, la tranchée d'isolation 110 comprend au moins un oxyde formé par dépôt chimique en phase vapeur assisté par plasma, cet oxyde est appelé par la suite oxyde PECVD.
- Avantageusement la couche de masquage 330 comprend au moins un oxyde formé par dépôt chimique en phase vapeur réalisée à pression sousatmosphérique, cet oxyde est appelé par la suite oxyde LPCVD.
- Avantageusement, l'oxyde PECVD est un oxyde de silicium.
- Avantageusement, l'oxyde LPCVD est un oxyde de silicium.
  Le choix des conditions de dépôt et de la nature des oxydes PECVD et LPCVD détermine leur vitesse de gravure respective lors de l'étape de gravure sèche 400. Selon un mode de réalisation de la présente invention, les conditions de formation et de gravure de ces deux oxydes sont configurées pour que le temps de gravure total de l'oxyde LPCVD corresponde à la gravure de l'épaisseur souhaitée de l'oxyde PECVD.
- Avantageusement, la gravure sèche 400, l'oxyde 110 formé par dépôt chimique en phase vapeur assisté par plasma et l'oxyde 330 formé par dépôt chimique en phase vapeur réalisée à pression sousatmosphérique sont configurés, en particulier l'épaisseur de ces oxydes et/ou leur sélectivité à la gravure, pour que le temps de formation de l'au moins une partie gravée de la tranchée isolante 112 corresponde au temps de gravure de la totalité de l'épaisseur de la couche de masquage 330.
- Selon un exemple, l'étape d'ajustement de la hauteur de la surface 221a de l'au moins une deuxième région active amincie 220a à la hauteur de la surface 113 de ladite partie gravée de la tranchée isolante 112 comprend au moins les étapes suivantes :

∘ oxydation d'au moins une portion de la deuxième région active amincie 220a de sorte à former une couche d'oxyde sacrificielle 225 ;
∘ retrait au moins partiel de la couche d'oxyde sacrificielle 225 de sorte à former une couche d'oxyde sacrificielle résiduelle 230 et de sorte à ce que la surface 231 de la couche d'oxyde sacrificielle résiduelle 230 soit à la même hauteur que la surface 113 de la partie non recouverte de la tranchée isolante gravée 112.

- Avantageusement, la couche d'oxyde sacrificielle 225 est formée par une étape d'oxydation sur une partie de l'épaisseur de l'au moins une deuxième région active amincie 220a.
- Selon un mode de réalisation, la couche d'oxyde sacrificielle 225 a une épaisseur comprise de préférence entre 2 nm et 20 nm, avantageusement entre 5nm et 15nm, et préférentiellement égale à 7.5 nm.
- Avantageusement, la couche d'oxyde sacrificielle 225 a une épaisseur comprise de préférence entre 6nm et 8nm, et avantageusement égale à 5nm.
- Avantageusement, la couche d'oxyde sacrificielle résiduelle 230 a une épaisseur comprise de préférence entre 0 et 10 nm, avantageusement entre 2 nm et 7 nm, et préférentiellement égale à 5 nm.
- Avantageusement, la gravure sèche 400 est une gravure par plasma.
- Avantageusement, le plasma est un plasma haute densité.
- Avantageusement, les paramètres de la gravure sèche par plasma sont :

∘ 1ère phase (dite de percée ou de Breakthrough)

▪ Puissance source TCP 500W ;
▪ Pression 4mT ;
▪ Pression d'Hélium (He) au dos de tranche (He Cooling) 8T ;
▪ CF4 50 sccm (Standard Cubic Centimeter per Minute, débit en centimètre cube par minute mesuré dans les conditions standard de température et de pression) ;
▪ Puissance de polarisation (en anglais « bias ») 50W ;

∘ 2ème phase (dite de gravure silicium)

▪ Puissance source TCP 600W ;
▪ Pression 25mT ;
▪ Pression d'Hélium au dos de tranche (He Cooling) 8T ;
▪ Cl2 125 sccm O2 19 sccm ;

▪ Puissance de polarisation (en anglais « bias ») 400W ;

∘ 3ème phase (dite de nettoyage final)

▪ Puissance source TCP 1200W ;
▪ Pression 10mT ;
▪ Pression d'Hélium au dos de tranche (He Cooling) 8T ;
▪ Argon (Ar) 120 sccm / O2 12 sccm / CF4 60 sccm;
▪ Puissance de polarisation (en anglais « bias ») 0W.

- Avantageusement, la couche active 200 a une épaisseur initiale comprise de préférence entre 100 nm et 200 nm, avantageusement entre 125 nm et 180 nm, et préférentiellement égale à 140 nm.
- Avantageusement, la première région active 210 a une épaisseur comprise de préférence entre 100 nm et 200 nm, avantageusement entre 125 nm et 180 nm, et préférentiellement égale à 140 nm.
- Avantageusement, l'au moins une deuxième région active amincie 220a a une épaisseur comprise de préférence entre 25 nm et 100 nm, avantageusement entre 50nm et 85nm, et préférentiellement égale à 70nm.
- Avantageusement, l'étape de gravure sèche 400 est suivie d'une étape de nettoyage humide de la surface desdites zones gravées.
- Avantageusement, l'étape de nettoyage humide de la surface desdites zones gravées est configurée pour éliminer des matériaux résiduels issus de l'étape de gravure sèche 400.
- Avantageusement, les matériaux résiduels sont des oxydes du matériau semi-conducteur.
- Avantageusement, la tranchée isolante 110 est en contact avec la couche isolante 100.
- Avantageusement, l'étape de formation de la couche de masquage 330 au-dessus d'au moins la première région active 210 et sur une partie au moins de la tranchée isolante 110 est précédée de la formation d'une couche d'oxyde intermédiaire 310 sur la première région active 210.
- Avantageusement, l'étape de formation de la couche d'oxyde intermédiaire 310 sur la première région active 210 est suivie par la formation d'une couche de nitrure 320 au-dessus de la couche d'oxyde intermédiaire 310 de sorte à ce que la couche de masquage 330 soit au moins en partie en contact avec ladite couche de nitrure 320.
- Selon un mode de réalisation, la couche isolante 100 a une épaisseur comprise entre 50 nm et 1000 nm, avantageusement entre 200 nm et 600nm et de préférence égale à 400 nm.
- Avantageusement, la couche d'oxyde intermédiaire 310 a une épaisseur comprise entre 1 nm et 10 nm, et de préférence entre 2 nm et 7 nm, et préférentiellement égale à 5 nm.

- Avantageusement, la couche de nitrure 320 a une épaisseur comprise entre 10nm et 150nm, et de préférence entre 50nm et 100nm, et préférentiellement égale à 70nm.

- Selon un mode de réalisation l'épaisseur des STI 110 est comprise entre 100 nm et 200 nm, avantageusement entre 125 nm et 180 nm, et préférentiellement égale à 140 nm.

- Avantageusement, l'épaisseur de la couche de masquage 330 est comprise entre 20 nm et 100 nm, de préférence entre 35 nm et 65 nm, et avantageusement égale à 42.5 nm.

- Avantageusement, les conditions de formation de cet oxyde PECVD sont les suivantes :

  ○ 1ère phase :

    ■ $O_2$ 200 sccm,
    ■ $SiH_4$ 40 sccm,
    ■ $H_2$ 1200 sccm
    ■ Puissance Haute fréquence (13,56 MHz) 0 W
    ■ Puissance basse fréquence (250 kHz) 3000W

  ○ 2ème phase :

    ■ $O_2$ 77 sccm,
    ■ $SiH_4$ 40 sccm,
    ■ $H_2$ 1200 sccm
    ■ Puissance Haute fréquence (13,56 MHz) 2450W
    ■ Puissance basse fréquence (250 kHz) 2750W

  ○ 3ème phase :

    ■ $O_2$ 104 sccm,
    ■ $SiH_4$ 55 sccm,
    ■ $H_2$ 1200 sccm
    ■ Puissance Haute fréquence (13,56 MHz) 3000W
    ■ Puissance basse fréquence (250 kHz) 2750W

- Avantageusement, les conditions de formations de cette couche de masquage 330 par LPCVD sont les suivantes : Température 650°C, pression 250 mTorr, débit de TEOS 100CC / minute.

- Avantageusement, l'étape de nettoyage humide est réalisée à base d'acide fluorhydrique de type DHF / SC1 / SC2 et comprend les paramètres suivants :

  ○ DHF18 SC1 SC2 sur FSI
  ○ HF 170 cc/mn + Eau DI chaude 1700 cc/mn 88 sec
  ○ SC1 : H2O2 200 cc/ mn NH4OH 125cc/mn Eau DI Chaude 1500 cc/mn 45sec
  ○ NH4OH 40 cc/mn Eau Di Chaude 1600 cc/mn 180 sec
  ○ SC2 : HCL 40 cc/mn H202 = 200 cc/m, Eau DI Chaude 1600cc/mn

Un exemple de réalisation de l'invention va maintenant être détaillé en référence aux figures.

La présente invention prévoit un procédé de fabrication sur un même substrat SOI 10 de transistors PDSOI et de transistors FDSOI. Un tel substrat 10 comprend une fine couche superficielle d'un semi-conducteur monocristallin, avantageusement du silicium monocristallin, dite couche active 200. Cette couche active 200 repose sur une couche isolante 100. De préférence cette couche active 200 repose elle-même sur une couche de support, non représentée.

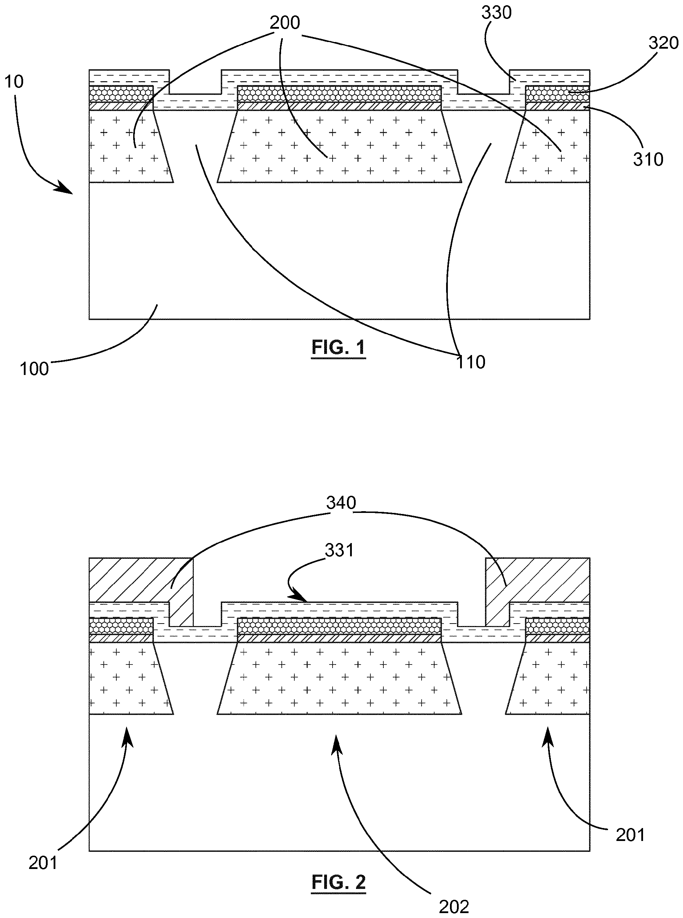

Selon un mode de réalisation dont le résultat est illustré par la figure 1, à partir de ce substrat SOI, une couche d'oxyde intermédiaire 310 est formée sur l'ensemble de la surface du substrat. Cette couche d'oxyde intermédiaire 310 comprend de préférence de l'oxyde de silicium.

Selon un mode de réalisation, une couche de nitrure 320 est déposée sur l'ensemble de la couche d'oxyde intermédiaire 310. Cette couche de nitrure 320 est avantageusement formée par LPCVD. Selon un mode de réalisation la composition chimique de cette couche de nitrure est Si3N4.

Une fois ces deux couches (310 et 320) formées, une série d'étapes de lithographies permet de former des tranchées isolantes 110 dites STI de leurs acronyme de l'anglais « Shallow trench isolation » illustrées dans la figure 1.

De manière très avantageuse, ces STI 110 sont formées à partir d'un oxyde PECVD, et de préférence d'un oxyde PECVD de silicium.

De préférence, les STI 110 sont en contact avec la BOX 100 comme illustré dans la figure 1.

Il est connu de l'Homme du métier de nombreuses techniques permettant de former des STI. Pour la présente invention, le critère de la nature de l'oxyde est un critère important. En effet, cet oxyde est de préférence un oxyde de silicium formé par PECVD.

Un mode de formation envisageable de ces STI 100 repose sur l'utilisation de techniques de lithographie classiques afin de former des tranchées dans le substrat 10. Ces tranchées sont alors ensuite remplies d'un oxyde, avantageusement d'un oxyde PECVD de silicium.

De part et d'autre de ces STI 110, des régions de la couche actives 200 sont définies. Une première région active 210 est dite région active PDSOI car elle est destinée à former des transistors PDSOI 700. Une deuxième région active 220 est dite région active FDSOI car elle est destinée à former des transistors FDSOI 600.

Une fois ces régions 210 et 220 définies par la formation des STI 110, une couche de masquage 330 est déposée selon de préférence un dépôt conforme afin de former la couche 330 illustrée en la figure 1.

De manière très avantageuse, la couche de masquage 330 comprend un oxyde LPCVD, et de préférence un oxyde LPCVD de silicium. Cette couche de masquage 330 peut également être appelée masque dur ou « hard mask » en anglais.

Une fois la couche de masquage 330 formée, nous obtenons un substrat tel qu'illustré par la figure 1.

On définit alors deux zones illustrées en figure 2 :

    ◦ une zone PDSOI 201 comprenant une région active PDSOI 210, c'est-à-dire une couche active 210 destinée à la formation d'au moins un transistor PDSOI 700, et comprenant une portion des STI 110 situées de part et d'autre de la couche active 210.

    ◦ une zone FDSOI 202 comprenant une région active FDSOI 220, c'est-à-dire une couche active 220 destinée à la formation d'au moins un transistor FDSOI 600, et comprenant une portion des STI 110 situées de part et d'autre de la couche active 220.

La figure 2 illustre également le dépôt au-dessus des zones PDSOI d'une couche protectrice 340, avantageusement comprenant une résine. Cette couche protectrice 340 est avantageusement déposée sur une partie au moins de la surface 331 de la couche de masquage 330.

Selon un mode de réalisation préféré, la couche protectrice 340 est déposée de manière à recouvrir une partie des STI 110, de préférence sensiblement 50% de leur surface. Elle est ouverte par l'un des nombreux procédés connus de lithographie, par exemple de photolithographie s'il s'agit d'une résine photosensible.

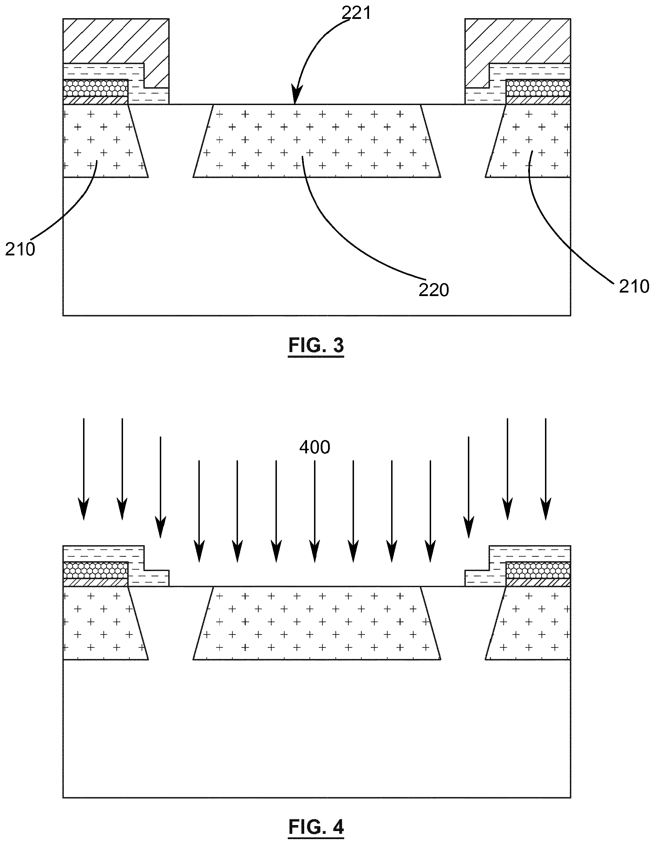

La figure 3 illustre une étape de gravure des zones FDSOI de manière à retirer la couche de masquage 330, la couche de nitrure 320 et la couche d'oxyde intermédiaire 310. Cette étape de gravure est préférentiellement réalisée par voie chimique à base d'une chimie Fluorocarbonée par exemple. Cette gravure, de préférence humide, a pour résultat d'exposer la surface 221 de la région active FDSOI 220, ainsi qu'une partie au moins de la surface des STI 110.

La figure 4 illustre l'étape de gravure sèche 400 configurée pour amincir la zone FDSOI 202, et plus particulièrement la couche active 220 et une portion au moins des STI 110, la portion non recouverte par la couche de masquage 330.

Cette étape de gravure sèche 400 est avantageusement précédée du retrait de la couche protectrice 340. Ce retrait peut avantageusement être réalisé à l'aide d'un plasma oxygène. Ce retrait est de préférence suivi d'un nettoyage humide afin de retirer tout résidu de la couche protectrice 340.

De plus, un nettoyage de l'oxyde natif présent à la surface du substrat peut être avantageusement réalisé par une chimie base de Tétrafluorure de carbone. Ce nettoyage prépare alors les surfaces de la zone FDSOI 202 à l'étape de gravure sèche 400.

L'étape de gravure sèche 400, réalisé par plasma, de préférence par un plasma haute densité, a pour objectif d'amincir la zone FDSOI. Ce plasma haute densité est avantageusement basé sur une chimie à base de chlore et d'oxygène.

Selon un mode de réalisation, la gravure sèche 400 par plasma haute densité est configurée pour atteindre une vitesse de gravure de l'ordre de 1 nm par seconde pour les matériaux considérés, et de préférence pour la couche active 220 avantageusement composée de silicium monocristallin.

De manière préférée, cette gravure sèche 400 est assujettie à une boucle rétroactive de mesure de l'épaisseur gravée, avantageusement par interférométrie. Ainsi, la gravure est opérée par multiples gravures successives séparées d'une mesure interférométrique de l'épaisseur consommée des matériaux considérés et de préférence de la couche active 220.

Avantageusement, cette gravure sèche 400 est configurée pour amincir la couche active 220 de la région FDSOI.

Préférentiellement, cette gravure sèche 400 est configurée pour amincir une portion des STI 110, portion appartenant à la région FDSOI.

De préférence, cette gravure sèche 400 est configurée pour retirer totalement la couche de masquage 330, avantageusement de l'ensemble du substrat 10.

De manière particulièrement astucieuse, cette gravure sèche 400 est configurée pour simultanément amincir deux matériaux de nature différente et retirer un troisième matériau. Ladite gravure sèche 400 est configurée pour que le temps de retrait total de la couche de masquage 330 corresponde au temps de gravure nécessaire à l'amincissement souhaité des portions des STI 110 et de la couche active 220.

Un des avantages de cette étape de gravure sèche 400 est la possibilité d'atteindre une épaisseur optimale de la couche active amincie 220a de l'ordre de 75 nm pour la formation de transistors FDSOI 600.

Cette étape de gravure sèche 400 est particulièrement innovante du fait qu'en une seule étape, la couche active 220 est amincie afin d'atteindre l'épaisseur souhaitée pour la formation de transistors FDSOI 600, la couche de masquage 330 est retirée des régions PDSOI et une portion des STI 110, entourant les couches actives 220, est amincie également.

Cette étape de gravure sèche 400 permet d'éviter l'utilisation de multiples gravures chimiques qui, en termes à la fois de temps de procédé et de coûts, n'est pas économique.

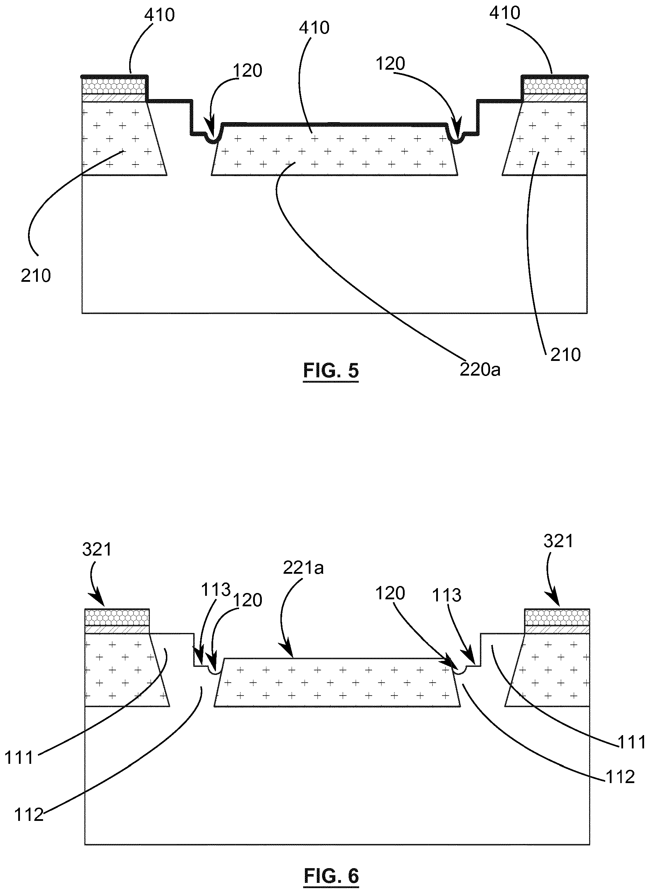

Les matériaux intervenant dans cette étape de gravure sèche 400 ont été choisis et formés spécifiquement afin de satisfaire les conditions de vitesses de gravure relatives afin d'obtenir le résultat illustré en figure 5.

La figure 5 illustre le résultat de la gravure sèche 400 décrite précédemment. La couche active amincie 220a et les parties gravées des STI 112 ont été formées en même temps que le retrait total de la couche de masquage 330.

En conséquence de cette gravure sèche 400, une couche d'oxyde résiduelle 410 a été formée sur l'ensemble des surfaces gravées, par exemple sur l'ensemble du substrat 10. Il s'agit d'un résidu de l'étape de gravure sèche 400.

On remarque également la formation de cavités 120, dites gouttières 120 de par leur forme géométrique, aux interfaces verticales entre la couche active 220a et les parties gravées des STI 112.

Ce phénomène de gouttière 120 est bien connu de l'Homme du métier, il est traditionnellement observé aux interfaces verticales entre deux matériaux de nature différente lors d'une gravure simultanée de ces deux matériaux. Ce phénomène est une des raisons qui détournerait l'Homme du métier de la présente invention. En effet, cette discontinuité structurelle semble aux premiers abords un défaut affectant les performances des transistors FDSOI 600.

Cependant, au cours de la mise au point de la présente invention, il a été noté, et cela de manière surprenante, que ces défauts structurels 120, c'est à dire ces gouttières 120, peuvent être amoindries et qu'elles ne présentent alors pas ou que peu de limitations quant aux performances des transistors FDSOI 600.

En effet, les gouttières 120 sont amoindries par l'ajustement des différents procédés de gravure chimique. De fait, la profondeur des gouttières 120 dans les zones de transistors FDSOI se trouve réduite et évite la présence après la gravure du polysilicium de la grille, de filaments de polysilicium source de connexions parasites entre les différentes lignes de polysilicium des transistors FDSOI.

Comme il sera présenté ci-après, ces gouttières 120 se remplissent de matériaux polycristallins lors des étapes ultérieures de formation des transistors FDSOI 600 et principalement de la grille desdits transistors FDSOI 600.

Une étape de nettoyage humide, illustrée en figure 6, fait suite à la gravure sèche 400. Ce nettoyage humide est configuré pour retirer la couche d'oxyde résiduelle 410 de l'ensemble des surfaces considérées.

Par exemple, ce nettoyage humide peut être réalisé à base d'acide fluorhydrique, de préférence dilué.

Ce nettoyage humide est configuré pour mettre à nu au moins l'une parmi les surfaces suivantes :

- ◦ la surface 321 de la couche de nitrure 320 ;
- ◦ la surface 221a de la couche active amincie 220a ;
- ◦ la surface des gouttières 120 ;
- ◦ la surface des STI 110.

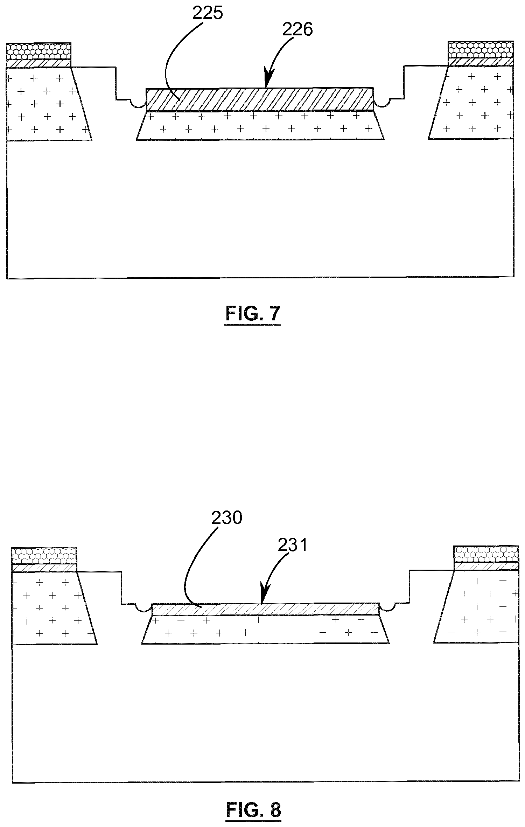

Les figures 7 et 8 illustrent l'étape d'ajustement de la hauteur de la surface 221a de la couche active amincie 220a à la hauteur de la surface 113 des parties gravée des STI 112. Cet ajustement de hauteur permet alors, entre autre, d'amoindrir la forme géométrique des gouttières 120 de sorte à ce qu'elles ne présentent pas de limitation quant aux performances des transistors FDSOI.

Avantageusement, les gouttières 120 sont amoindries par l'ajustement des différents procédés de gravure chimique. De fait, la profondeur des gouttières dans les zones de transistors FDSOI se trouve réduite et évite la présence après la gravure du polysilicium de la grille, de filaments de polysilicium source de connexions parasites entre les différentes lignes de polysilicium des transistors FDSOI.

Cet ajustement de hauteur comprend au moins deux étapes : la formation d'une couche d'oxyde sacrificielle 225 et le retrait d'une portion au moins de cette couche d'oxyde sacrificielle 225.

La formation et le retrait partiel d'une couche d'oxyde sacrificielle 225 agissent en synergie avec l'étape de gravure sèche 400 précédente pour réduire les coûts de production de dispositifs électroniques.

Tout d'abord, cette couche d'oxyde sacrificielle 225 permet d'améliorer l'état de surface de la couche active amincie 220a, c'est-à-dire de nettoyer structurellement la surface 221a. En effet, la surface 221a résulte d'une gravure sèche qui peut laisser la surface 221a endommagée au niveau cristallographique sur une très faible épaisseur de l'ordre de quelques nanomètres par exemple. Le retrait partiel de cette couche d'oxyde sacrificielle 225 permet alors de retirer la partie endommagée de la surface 221a en ne laissant qu'une couche d'oxyde sacrificielle résiduelle 230 dont la surface 231 ne présente plus ces dommages structurels.

Ensuite, le retrait partiel de la couche d'oxyde sacrificielle 225 permet la mise à niveau de la surface 231 de la couche d'oxyde sacrificielle résiduelle 230 avec la hauteur des surfaces 113 des parties gravées des STI 112. Cette mise à niveau supprime alors les effets limitants des gouttières 120 sur les performances des transistors FDSOI 600.

Pour finir, la couche d'oxyde sacrificielle résiduelle 230 forme un écran aux implantations ioniques ultérieurement réalisées dans le but de former des zones de sources (610, 710) et de drains (620, 720). Cet écran assure une meilleure homogénéité d'implantation en évitant les effets de canalisation et il permet également de limiter les dommages structurels dus aux implantations ioniques.

Ainsi, une seule étape d'ajustement de hauteur permet de rétablir une structure de surface absente de défauts, d'éliminer les inconvénients résultant de la formation de gouttières 120 et de permettre des implantations ioniques futures.

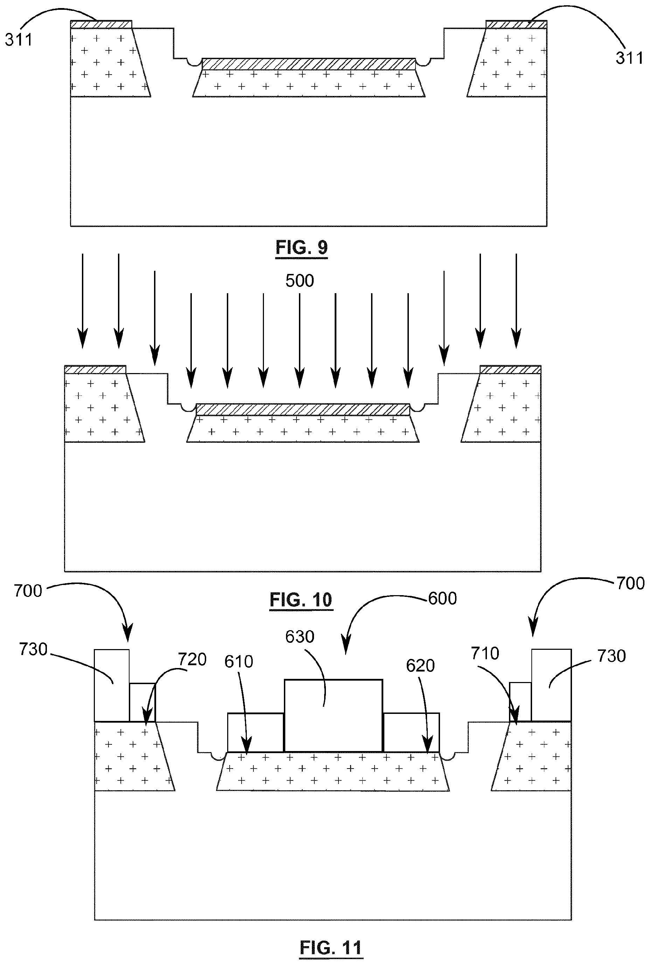

La figure 9 illustre une étape de retrait de la couche de nitrure 320 au niveau des zones PDSOI de sorte à mettre à nu la surface 311 de la couche d'oxyde intermédiaire 310. Ce retrait peut être réalisé par voie humide par exemple afin de ne pas endommager la surface 231.

La figure 10 illustre l'étape d'implantation ionique 500 afin de former des zones de sources et de drains.

Avantageusement, cette étape d'implantation ionique 500 peut comprendre deux sous étapes correspondant à une première implantation ionique des zones PDSOI suivie d'une deuxième implantation ionique des zones FDSOI. Cela permet ainsi de disposer de plusieurs degrés de liberté dans le choix des doses et des éléments implantés afin de répondre aux divers besoins en termes de caractéristiques des transistors PDSOI 700 et FDSOI 600.

Cette étape d'implantation ionique 500 bénéficie avantageusement de la présence de la couche d'oxyde intermédiaire 310 au niveau des zones PDSOI et de la couche d'oxyde sacrificielle résiduelle 231 au niveau des zones FDSOI afin d'assurer une bonne homogénéité d'implantation et de limiter les défauts structurels d'implantation ionique. Les couches d'oxyde intermédiaire 310 au niveau des zones PDSOI et d'oxyde sacrificielle résiduelle 231 au niveau des zones FDSOI jouent alors le rôle d'écran pour les optimiser la formation des sources et des drains.

La figure 11 illustre, selon un mode de réalisation, un transistor FDSOI 600 formé au-dessus de la région active FDSOI amincie 220a et deux transistors PDSOI 700, à moitié représentés dans la figure 11, formés au-dessus des régions actives PDSOI 210.

Dans la figure 11, chaque transistor est illustré sommairement. Chaque transistor comprend au moins une zone de source (610, 710) et une zone de drain (620, 720), surélevés dans cet exemple, une grille (630, 730) comprenant de préférence une pluralité de couches et potentiellement des espaceurs isolant électriquement les flancs de chaque grille (630, 730) des zones de sources (610, 710) et de drains (620, 720).

La figure 11 permet d'illustrer la position des transistors PDSOI 700 et des transistors FDSOI 600 par rapport aux zones PDSOI 201 et aux zones FDSOI 202 selon un mode de réalisation de la présente invention.

La présente invention concerne un procédé de fabrication d'un dispositif électronique apte à former sur une même tranche de silicium des transistors PDSOI et FDSOI. La présente invention comprend des étapes qui ont été étudiées, développées et optimisées afin de présenter entre elles une synergie de sorte à réduire les coûts de production d'un tel dispositif tout en ne sacrifiant pas les performances de ce type de dispositifs électroniques.

Ainsi, certaines des pluralités ont des effets multiples afin de réduire le nombre total d'étapes nécessaires.

L'invention n'est pas limitée aux modes de réalisations précédemment décrits et s'étend à tous les modes de réalisation couverts par les revendications.

REFERENCES

| 10. | Empilement de couches, substrat SOI |
| --- | --- |
| 100. | Couche isolante, BOX, oxyde de silicium |
| 110. | Tranchées isolantes, STI (Shallow Trench Isolation) |
| 111. | Partie recouverte des tranchées isolantes par la couche de masquage |
| 112. | Partie gravée des tranchées isolantes |
| 113. | Surface de la partie gravée des tranchées isolantes |
| 120. | Cavités, Gouttières |
| 200. | Couche active ; |
| 201. | Zone PDSOI |
| 202. | Zone FDSOI |
| 210. | Première région active, région active PDSOI, couche active |
| 220. | Deuxième région active, région active FDSOI, couche active |
| 220a. | Deuxième région active amincie, région active FDSOI amincie, couche active amincie |
| 221. | Surface de la deuxième région active |
| 221a. | Surface de la deuxième région active amincie |
| 225. | Couche d'oxyde sacrificielle |
| 226. | Surface de la couche d'oxyde sacrificielle |
| 230. | Couche d'oxyde sacrificielle résiduelle |
| 231. | Surface de la couche d'oxyde sacrificielle résiduelle |
| 310. | Couche d'oxyde intermédiaire |
| 311. | Surface de la couche d'oxyde intermédiaire |
| 320. | Couche de nitrure |
| 321. | Surface de la couche de nitrure |
| 330. | Couche de masquage |
| 331. | Surface de la couche de masquage |
| 340. | Couche protectrice, résine |
| 400. | Gravure sèche ; |
| 500. | Implantation ionique ; |
| 600. | Transistor totalement déserté, transistor FDSOI |
| 610. | Zone de source |
| 620. | Zone de drain |
| 630. | Grille |
| 700. | Transistor partiellement déserté, transistor PDSOI |
| 710. | Zone de source |
| 720. | Zone de drain |
| 730. | Grille |

**Revendications**

**1.** Procédé de formation d'un dispositif électronique destiné à accueillir au moins un transistor totalement déserté (FDSOI) (600) et au moins un transistor partiellement déserté (PDSOI) (700), à partir d'un empilement de couches (10) comprenant au moins une couche isolante (100) surmontée d'au moins une couche active (200) en un matériau semi-conducteur, le procédé comprenant au moins les étapes suivantes :

- former au moins une tranchée isolante (110) à travers l'épaisseur de la couche active (200) pour définir dans ladite couche active (200), de part et d'autre de la tranchée isolante (110), au moins une première région active (210) sur laquelle est destiné à être formé au moins un transistor PDSOI (700) et au moins une deuxième région active (220) sur laquelle est destiné à être formé au moins un transistor FDSOI (600) ;
- former, au-dessus de l'au moins une première région active (210) et sur une partie de la tranchée isolante (110), une couche de masquage (330) sans recouvrir l'au moins une deuxième région active (220) et sans recouvrir une partie de la tranchée isolante (110) ;
- graver (400) simultanément par une gravure sèche de sorte à former des zones gravées :

◦ une partie de l'épaisseur de la couche active (200) de l'au moins une deuxième région active (220) de manière à former au moins une deuxième région active amincie (220a) et à obtenir dans l'au moins une deuxième région active amincie (220a) une épaisseur de la couche active (200) plus faible que dans l'au moins une première région active (210),
◦ au moins une partie de l'épaisseur de la partie non recouverte de la tranchée isolante (110) de sorte à former une partie gravée de la tranchée isolante (112),
◦ et la totalité de la couche de masquage (330),

- ajuster, après l'étape de gravure sèche (400), la hauteur de la surface (221a) de l'au moins une deuxième région active amincie (220a) à la hauteur de la surface (113) de ladite une partie gravée de la tranchée isolante (112), l'étape d'ajustement de la hauteur de la surface (221a) de l'au moins une deuxième région active amincie (220a) à la hauteur de la surface (113) de ladite partie gravée de la tranchée isolante (112) comprenant au moins les étapes suivantes :

- oxydation d'au moins une portion de la deuxième région active amincie (220a) de sorte à former une couche d'oxyde sacrificielle (225) ;

- retrait partiel de la couche d'oxyde sacrificielle (225) de sorte à former une couche d'oxyde sacrificielle résiduelle (230) et de sorte à ce que la surface (231) de la couche d'oxyde sacrificielle résiduelle (230) soit à la même hauteur que la surface (113) de la partie gravée de la tranchée isolante (112).

2. Procédé selon la revendication précédente dans lequel la tranchée d'isolation (110) comprend au moins un oxyde formé par dépôt chimique en phase vapeur assisté par plasma.

3. Procédé selon l'une quelconque des revendications précédentes dans lequel la couche de masquage (330) comprend au moins un oxyde formé par dépôt chimique en phase vapeur réalisée à pression sous-atmosphérique.

4. Procédé selon les deux revendications précédentes dans lequel la gravure sèche (400), l'oxyde (110) formé par dépôt chimique en phase vapeur assisté par plasma et l'oxyde (330) formé par dépôt chimique en phase vapeur réalisée à pression sous-atmosphérique sont configurés pour que le temps de formation de l'au moins une partie gravée de la tranchée isolante (112) corresponde au temps de gravure de la totalité de l'épaisseur de la couche de masquage (330).

5. Procédé selon l'une quelconque des revendications précédentes dans lequel la couche d'oxyde sacrificielle (225) est formée par une étape d'oxydation sur une partie de l'épaisseur de l'au moins une deuxième région active amincie (220a).

6. Procédé selon l'une quelconque des revendications précédentes dans lequel la couche d'oxyde sacrificielle (225) a une épaisseur comprise de préférence entre 6nm et 8nm, et avantageusement égale à 5nm.

7. Procédé selon l'une quelconque des revendications précédentes dans lequel la gravure sèche (400) est une gravure par plasma.

8. Procédé selon la revendication précédente dans lequel le plasma est un plasma haute densité.

9. Procédé selon l'une quelconque des revendications précédentes dans lequel la couche active (200) a une épaisseur initiale comprise de préférence entre 100nm et 200nm, avantageusement entre 125nm et 180nm, et préférentiellement égale à 140nm, et dans lequel la première région active (210) a une épaisseur comprise de préférence entre 100nm et 200nm, avantageusement entre 125nm et 180nm, et préférentiellement égale à 140nm, et dans lequel l'au moins une deuxième région active amincie (220a) a une épaisseur comprise de préférence entre 25nm et 100nm, avantageusement entre 50nm et 85nm, et préférentiellement égale à 70nm.

10. Procédé selon l'une quelconque des revendications précédentes dans lequel l'étape de gravure sèche (400) est suivie d'une étape de nettoyage humide de la surface desdites zones gravées.

11. Procédé selon la revendication précédente dans lequel l'étape de nettoyage humide de la surface desdites zones gravées est configurée pour éliminer des matériaux résiduels issus de l'étape de gravure sèche (400).

12. Procédé selon l'une quelconque des revendications précédentes dans lequel la tranchée isolante (110) est en contact avec la couche isolante (100).

13. Procédé selon l'une quelconque des revendications précédentes dans lequel l'étape de formation de la couche de masquage (330) au-dessus d'au moins la première région active (210) et sur une partie au moins de la tranchée isolante (110) est précédée de la formation d'une couche d'oxyde intermédiaire (310) sur la première région active (210).

14. Procédé selon la revendication précédente dans lequel l'étape de formation de la couche d'oxyde intermédiaire (310) sur la première région active (210) est suivie par la formation d'une couche de nitrure (320) au-dessus de la couche d'oxyde intermédiaire (310) de sorte à ce que la couche de masquage (330) soit au moins en partie en contact avec ladite couche de nitrure (320).


**Patentansprüche**

1. Verfahren zur Bildung einer elektronischen Vorrichtung, die dazu bestimmt ist, mindestens einen vollständig verarmten Transistor (FDSOI) (600) und mindestens einen teilweise verarmten Transistor (PDSOI) (700) ausgehend von einer Stapelung von Schichten (10) zu empfangen, die mindestens eine isolierende Schicht (100) umfassen, die von mindestens einer aktiven Schicht (200) aus einem Halbleitermaterial überragt wird, wobei das Verfahren mindestens die folgenden Schritte umfasst:

- Bilden mindestens eines isolierenden Grabens (110) durch die Dicke der aktiven Schicht (200) hindurch, um in der aktiven Schicht (200) beiderseits des isolierenden Grabens (110) mindestens eine aktive Region (210) zu definieren, auf der mindestens ein PDSOI-Transistor (700) dazu bestimmt ist, gebildet zu werden, und mindestens eine zweite aktive Region (220), auf der mindestens ein FDSOI-Transistor (600) dazu bestimmt ist, gebildet zu werden;
- Bilden, oberhalb der mindestens einen ersten aktiven Region (210) und auf einem Teil des isolierenden Grabens (110), einer Maskierungsschicht (330), ohne die mindestens eine zweite aktive Region (220) abzudecken, und ohne einen Teil des isolierenden Grabens (110) abzudecken;
- gleichzeitiges Gravieren (400) durch eine Trockengravur, um gravierte Zonen zu bilden:

° eines Teils der Dicke der aktiven Schicht (200) der mindestens einen zweiten aktiven Region (220), um mindestens eine zweite dünner gemachte aktive Region (220a) und um in der mindestens einen zweiten dünner gemachten aktiven Region (220a) eine Dicke der aktiven Schicht (200) zu erhalten, die geringer ist, als in der mindestens einen ersten aktiven Region (210),
° mindestens eines Teils der Dicke des nicht abgedeckten Teils des isolierenden Grabens (110), um einen gravierten Teil des isolierenden Grabens (112) zu bilden,
° und der gesamten Maskierungsschicht (330),

- Anpassen, nach dem Trockengravurschritt (400), der Höhe der Oberfläche (221a) der mindestens einen zweiten dünner gemachten aktiven Region (220a) an die Höhe der Oberfläche (113) des einen gravierten Teils des isolierenden Grabens (112), wobei der Schritt des Anpassens der Höhe der Oberfläche (221a) der mindestens einen zweiten dünner gemachten aktiven Region (220a) an die Höhe der Oberfläche (113) des einen gravierten Teils des isolierenden Grabens (112) mindestens die folgenden Schritte umfasst:
- Oxidieren mindestens eines Abschnitts der zweiten dünner gemachten aktiven Region (220a) um eine Oxidopferschicht (225) zu bilden;
- teilweise Abheben der Oxidopferschicht (225) um eine Restoxidopferschicht (230) zu bilden, und derart, dass die Oberfläche (231) der Restoxidopferschicht (230) auf derselben Höhe wie die Oberfläche (113) des gravierten Teils des isolierenden Grabens (112) ist.

2. Verfahren nach dem vorstehenden Anspruch, wobei der isolierende Graben (110) mindestens ein Oxid umfasst, welches durch plasmaunterstützte chemische Gasphasenabscheidung gebildet wird.

3. Verfahren nach einem der vorstehenden Ansprüche, wobei die Maskierungsschicht (330) mindestens ein Oxid umfasst, welches durch chemische Gasphasenabscheidung bei Unterdruck gebildet wird.

4. Verfahren nach den beiden vorstehenden Ansprüchen, wobei die Trockengravur (400), das durch plasmaunterstützte chemische Gasphasenabscheidung gebildete Oxid (110) und das durch chemische Gasphasenabscheidung bei Unterdruck gebildete Oxid (330) konfiguriert sind, damit die Bildungszeit des mindestens einen gravierten Teils des isolierenden Grabens (112) der Gravierzeit der Gesamtheit der Dicke der Maskierungsschicht (330) entspricht.

5. Verfahren nach einem der vorstehenden Ansprüche, wobei die Oxidopferschicht (225) durch einen Oxidierungsschritt auf einem Teil der Dicke der mindestens einen zweiten dünner gemachten aktiven Region (220a) gebildet wird.

6. Verfahren nach einem der vorstehenden Ansprüche, wobei die Oxidopferschicht (225) eine Dicke aufweist, die vorzugsweise zwischen 6 nm und 8 nm enthalten ist, und vorteilshalber gleich 5 nm ist.

7. Verfahren nach einem der vorstehenden Ansprüche, wobei die Trockengravur (400) eine Plasmagravur ist.

8. Verfahren nach dem vorstehenden Anspruch, wobei das Plasma ein hochdichtes Plasma ist.

9. Verfahren nach einem der vorstehenden Ansprüche, wobei die aktive Schicht (200) eine ursprüngliche Dicke aufweist, die vorzugsweise zwischen 100 nm und 200 nm, vorteilshalber zwischen 125 nm und 180 nm enthalten ist, und vorzugsweise gleich 140 nm beträgt, und wobei die erste aktive Region (210) eine Dicke aufweist, die vorzugsweise zwischen 100 nm und 200 nm, vorteilshalber zwischen 125 nm und 180 nm enthalten ist, und vorzugsweise gleich 140 nm beträgt, und wobei die mindestens eine zweite dünner gemachte aktive Region (220a) eine Dicke aufweist, die vorzugsweise zwischen 25 nm und 100 nm, vorteilshalber zwischen 50 nm und 85 nm enthalten ist, und vorzugsweise gleich 70 nm beträgt.

10. Verfahren nach einem der vorstehenden Ansprüche, wobei auf den Schritt der Trockengravur (400) ein Feuchtreinigungsschritt der Oberfläche der gravierten Zonen folgt.

11. Verfahren nach dem vorstehenden Anspruch, wobei der Feuchtreinigungsschritt der Oberfläche der gravierten Zonen konfiguriert ist, um verbliebene, aus dem Schritt der Trockengravur (400) stammende Materialien zu beseitigen.

12. Verfahren nach einem der vorstehenden Ansprüche, wobei der isolierende Graben (110) in Kontakt mit der isolierenden Schicht (100) ist.

13. Verfahren nach einem der vorstehenden Ansprüche, wobei dem Schritt zur Bildung der Maskierungsschicht (330) oberhalb von mindestens der ersten aktiven Region (210) und auf mindestens einem Teil des isolierenden Grabens (110) die Bildung einer Zwischenoxidschicht (310) auf der ersten aktiven Region (210) vorangeht.

14. Verfahren nach dem vorstehenden Anspruch, wobei auf den Schritt zur Bildung einer Zwischenoxidschicht (310) auf der ersten aktiven Region (210) die Bildung einer Nitridschicht (320) oberhalb der Zwischenoxidschicht (310) folgt, sodass die Maskierungsschicht (330) mindestens teilweise in Kontakt mit der Nitridschicht (320 ist.

## Claims

1. Method for forming an electronic device intended to receive at least one fully depleted (FDSOI) transistor (600) and at least one partially depleted (PDSOI) transistor (700), from a stack of layers (10) comprising at least one insulating layer (100) topped with at least one active layer (200) made of a semiconductor material, the method comprising at least the following steps:

   - forming at least one insulating trench (110) through the thickness of the active layer (200) to define in said active layer (200), on either side of the insulating trench (110), at least one first active region (210) whereon at least one PDSOI transistor (700) is intended to be formed and at least one second active region (220) wherein at least one FDSOI transistor (600) is intended to be formed;
   - forming, on top of the at least one first active region (210) and on a part of the insulating trench (110), a masking layer (330) without covering the at least one second active region (220) and without covering a part of the insulating trench (110);
   - etching (400) simultaneously by dry etching so as to form etched zones:

     ∘ a part of the thickness of the active layer (200) of the at least one second active region (220) so as to form at least one second thinned active region (220a) and to obtain in the at least one second thinned active region (220a) a smaller thickness of the active layer (200) than in the at least one first active region (210),
     ∘ at least one part of the thickness of the non-covered part of the insulating trench (110) so as to form an etched part of the insulating trench (112),
  ◦ and the entire masking layer (330),

- adjusting, after the dry etching step (400), the height of the surface (221a) of the at least one second thinned active region (220a) to the height of the surface (113) of said an etched part of the insulating trench (112), the step of adjusting the height of the surface (221a) of the at least one second thinned active region (220a) to the height of the surface (113) of said etched part of the insulating trench (112) comprising at least the following steps:
- oxidising at least one portion of the second thinned active region (220a) so as to form a sacrificial oxide layer (225);
- partially removing the sacrificial oxide layer (225) so as to form a residual sacrificial oxide layer (230) and such that the surface (231) of the residual sacrificial oxide layer (230) is at the same height as the surface (113) of the etched part of the insulating trench (112).

2. Method according to the preceding claim wherein the insulation trench (11) comprises at least one oxide formed by plasma-enhanced chemical vapour deposition.

3. Method according to any one of the preceding claims wherein the masking layer (330) comprises at least one oxide formed by chemical vapour deposition conducted at sub-atmospheric pressure.

4. Method according to the two preceding claims wherein the dry etching (400), the oxide (110) formed by plasma-enhanced chemical vapour deposition and the oxide (330) formed by chemical vapour deposition conducted at sub-atmospheric pressure are configured so that the formation time of the at least one etched part of the insulating trench (112) corresponds to the etching time of the entire thickness of the masking layer (330).

5. Method according to any one of the preceding claims wherein the sacrificial oxide layer (225) is formed by an oxidation step on a part of the thickness of the at least one second thinned active region (220a).

6. Method according to any one of the preceding claims wherein the sacrificial oxide layer (225) has a thickness preferably between 6 nm and 8 nm, and advantageously equal to 5 nm.

7. Method according to any one of the preceding claims wherein the dry etching (400) is a plasma etching.

8. Method according to the preceding claim wherein the plasma is a high-density plasma.

9. Method according to any one of the preceding claims wherein the active layer (200) has an initial thickness preferably between 100 nm and 200 nm, advantageously between 125 nm and 180 nm, and preferably equal to 140 nm, and wherein the first active region (210) has a thickness preferably between 100 nm and 200 nm, advantageously between 125 nm and 180 nm, and preferably equal to 140 nm, and wherein the at least one second thinned active region (220a) has a thickness preferably between 25 nm and 100 nm, advantageously between 50 nm and 85 nm, and preferably equal to 70 nm.

10. Method according to any one of the preceding claims wherein the dry etching step (400) is followed by a step of wet cleaning the surfaces of said etched zones.

11. Method according to the preceding claim wherein the step of wet cleaning the surface of said etched zones is configured to remove residual materials from the dry etching step (400).

12. Method according to any one of the preceding claims wherein the insulating trench (110) is in contact with the insulating layer (100).

13. Method according to any one of the preceding claims wherein the step of forming the masking layer (330) on top of at least the first active region (210) and on a part at least of the insulating trench (110) is preceded by forming an intermediate oxide layer (310) on the first active region (210).

14. Method according to the preceding claim wherein the step of forming the intermediate oxide layer (310) on the first active region (210) is followed by forming a nitride layer (320) on top of the intermediate oxide layer (310) such that the masking layer (330) is at least partially in contact with said nitride layer (320).

**FIG. 1**

**FIG. 2**

**FIG. 3**

**FIG. 4**

410    410    120    410

120

120

210

210

220a

**FIG. 5**

321    221a    321

113 120    120    113

111

111

112

112

**FIG. 6**

FIG. 7

FIG. 8

311

311

**FIG. 9**

500

**FIG. 10**

700

700

730

720

610

630

600

620

710

730

**FIG. 11**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 03054966 A1
- US 20060216898 A1
- US 20020072225 A1